# EUROPEAN PATENT APPLICATION

(11) **EP 0 887 766 A2**
(43) Date of publication of application: **30.12.1998**
(21) Application number: 98111543.9
(22) Date of filing: 23.06.1998
(51) Int. Cl.: G06K 19/077

(54) **IC card having a slit for protecting an IC module from an external stress**

(30) Priority: 23.06.1997 JP 165801/97
(71) Applicant: NEC CORPORATION, Tokyo (JP)
(72) Inventor: Satou, Takemitsu, Yamagata-shi, Yamagata (JP)
(74) Representative: Glawe, Delfs, Moll & Partner

(57) **Abstract**

An IC card includes a card body and an IC module embedded in and flush-mounted on the card body. The card body includes a plurality of slits formed to penetrate through the card body and located to surround a periphery of the IC module.

## Description

### Background of the Invention

### Field of the invention

The present invention relates to an IC (integrated circuit) card, which is also called a chip card or a smart card, and which is currently used as a credit card or a cash card, and more specifically to an IC card configured to protect an IC module from an external stress.

### Description of related art

Recently, an IC card starts to spread as a card type medium capable of storing a large amount of information. In brief, the IC card is constituted of an IC module flush-mounted on a front face of a card body, which is formed of for example a vinyl chloride resin. The IC module is composed of a printed substrate having a front surface formed with a plurality of terminal contacts and a rear surface on which an IC chip is mounted and encapsulated with resin. The IC chip mounted on the rear surface of the printed substrate is electrically connected to the terminal contacts formed on the front surface of the printed substrate.

Japanese Patent Application Pre-examination Publication Nos. JP-A-63-091294 and JP-A-02-301155 propose an IC card in which the whole of an IC module is fixed on a card body by an adhesive, which will be called a "first prior art IC card".

However, the following fatal problem has been encountered in this first prior art IC card. With en expansion of the function of the IC card, the size of the IC chip internally incorporated in the IC module has become large, with the result that a stress occurring due to a handling of the IC card is transferred to the IC module, to cause an IC module trouble such as disconnection or destruction of the IC chip in an extreme case.

In order to avoid the above mentioned problem, Japanese Patent Application Pre-examination Publication No. JP-A-04-201393 proposes another IC card in which a substrate of an IC module is formed of a flexible material such as a polyimide film, and a peripheral portion of the IC module substrate is left in the form of a brim and only the brim portion is bonded to the card body. This construction is intended to absorb the stress transferred through the card body to the IC module, by the flexible IC module substrate. This will be called a "second prior art IC card".

However, this second prior art IC card still has problems. First, since the brim portion is bonded integrally to the card body by the adhesive bonding, it is not possible to satisfactorily absorb the stress. In addition, since a bonding portion becomes a rigid structure, the bonding portion has no capability of cutting off the propagation of an external stress. Secondly, since an expensive polyimide film is used, the cost of materials for the IC module increases. Furthermore, in order to bond only the brim portion to the card body, it is necessary to precisely control the deposited amount of adhesive. Therefore, the cost of manufacturing for the IC card increases. In addition, the bonding strength between the card body and the IC module is apt to drop, so that when a large stress is applied, the IC module is pealed off from the card body. On the other hand, if the size of the IC chip increases, the size of the flexible portion becomes relatively small, with the result that the stress absorbing effect of the flexible structure becomes relatively insufficient.

In order to overcome the above mentioned problems, Japanese Patent Application Pre-examination Publication No. JP-A-08-318692 (an English abstract of JP-A-08-318692 is available from the Japanese Patent Office and the content of the English abstract of JP-A-08-318692 is incorporated by reference in its entirety into this application) proposes to form grooves on one surface of the card body to substantially surround the mounted IC module, so as to suppress the transfer of the stress. This will be called a "third prior art IC card".

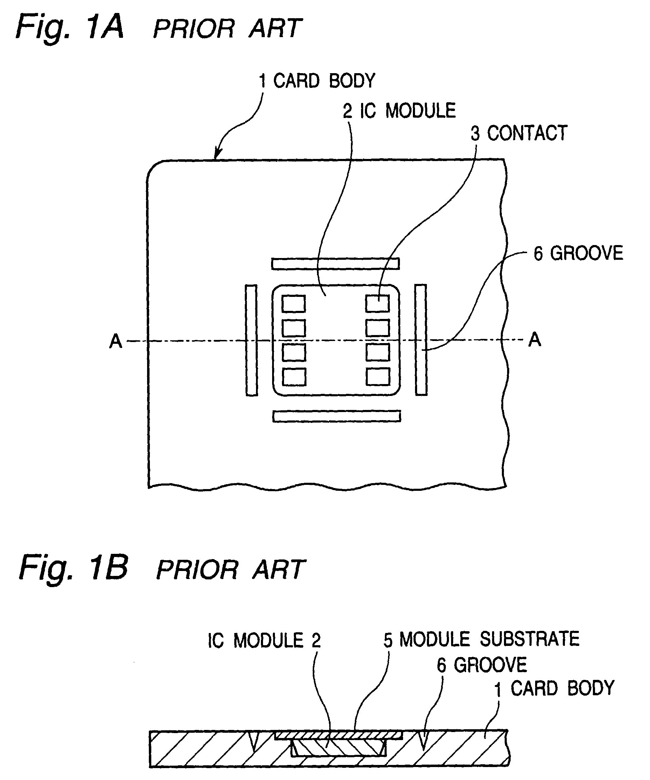

This third prior art IC card will be described with reference to Figs. 1A and 1B. Fig. 1A is a diagrammatic partial plan view of the third prior art IC card, and Fig. 1B is a diagrammatic partial sectional view taken along the line A-A in Fig. 1A.

As shown in Figs. 1A and 1B, the third prior art IC card comprises a card body 1, which is formed of for example a vinyl chloride resin, and an IC module 2 which includes a module substrate 5 having a plurality of terminal contacts 3 formed on one surface thereof and which is flush-mounted on one face of the card body 1. A plurality of grooves 6 are formed on the one face of the card body 1, to surround the IC module 2. As well known to persons skilled in the art, an IC chip (not shown) is mounted on the other surface of module substrate 5 and is electrically connected to the terminal contacts 3 (through not-shown means). The IC chip is encapsulated with resin on the other surface of module substrate 5.

Now, a stress suppressing operation of the third prior art IC card will be described with Figs. 1A and 1B. When an stress is applied to the card body 1 from an external, a major portion of the stress transferred towards the IC module 2 is cut off at the grooves 6, so that the major portion of the stress does not reach the IC module.

However, in this third prior art IC card, since the surface of the card body 1 opposite to the groove-formed surface is formed of the same material as that of the card body 1, the stress propagating at the groove-formed surface is substantially cut off, but for example, the stress propagating at the opposite surface is not cut off at all. As a result, the cut-off effect is not satisfactory to all stress propagating directions caused by ordinary various handling of the IC card.

### Summary of the Invention

Accordingly, it is an object of the present invention to provide an IC card which has overcome the above mentioned problems of the prior art.

Another object of the present invention is to provide an IC card which is configured to surely cut off an external stress so as to prevent a trouble and a destruction of an IC module which would otherwise be caused by the external stress, and which can be manufactured inexpensively.

The above and other objects of the present invention are achieved in accordance with the present invention by an IC card including a card body and an IC module embedded in the card body, the card body including a plurality of slits formed to penetrate through the card body and located to surround a periphery of the IC module.

In an embodiment, the IC module is rectangular in a plan view, and the plurality of slits consists of four slits, each of which extends in parallel to a corresponding side of four sides of the rectangular IC module, separately from the corresponding side. In addition, each of the four slits has a length substantially equal to that of a corresponding side of the rectangular IC module, and opposite ends of each slit terminate in the proximity of opposite corners of the corresponding side of the rectangular IC module, respectively, separately from an adjacent end of an adjacent elongated slit. Furthermore, each of the slits completely penetrates through the card body so that a mouth formed in one surface of the card body by the penetrating slit is substantially the same in shape and in size as a mouth formed in the other surface of the card body by the same penetrating slit.

In a preferred embodiment, each of slits is filled with a flexible filler, which is formed of for example, a rubber.

The above and other objects, features and advantages of the present invention will be apparent from the following description of preferred embodiments of the invention with reference to the accompanying drawings.

### Brief Description of the Drawings

Fig. 1A is a diagrammatic partial plan view of the third prior art IC card;
Fig. 1B is a diagrammatic partial sectional view taken along the line A-A in Fig. 1A;
Fig. 2A is a diagrammatic partial plan view of a first embodiment of the IC card in accordance with the present invention;
Fig. 2B is a diagrammatic partial sectional view taken along the line B-B in Fig. 2A; and
Fig. 3 is a diagrammatic partial sectional view illustrating a second embodiment of the IC card in accordance with the present invention.

### Description of the Preferred embodiments

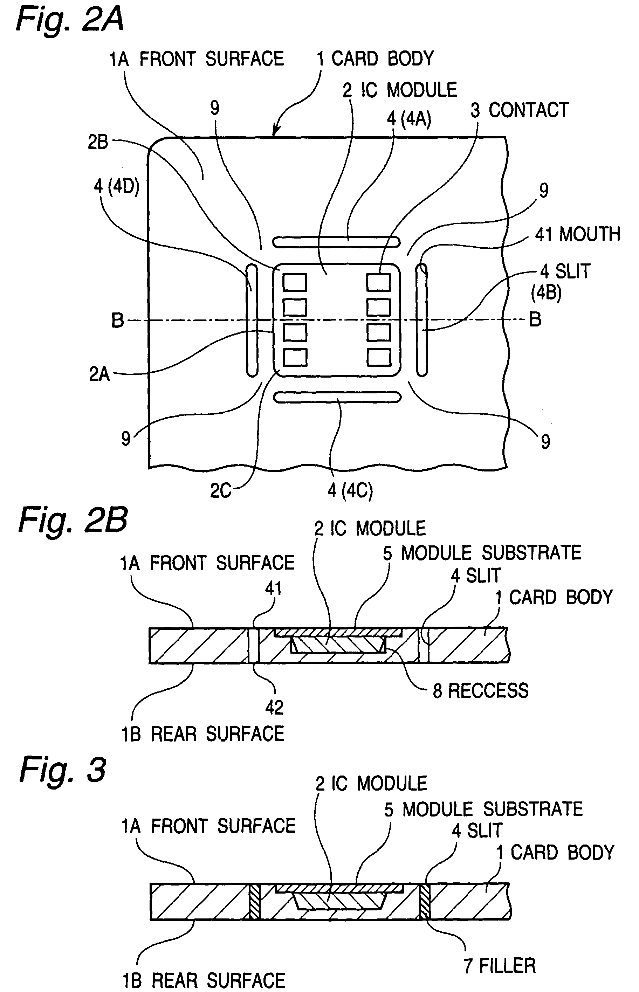

A first embodiment of the IC card in accordance with the present invention will be described with reference to Figs. 2A and 2B. Fig. 2A is a diagrammatic plan view of a part including an IC module, of the first embodiment of the IC card in accordance with the present invention, and Fig. 2B is a diagrammatic partial sectional view taken along the line B-B in Fig. 2A. In Figs. 2A and 2B, elements corresponding to those shown in Figs. 1A and 1B are given the same Reference Numerals.

Similarly to the prior art IC card, the shown embodiment of the IC card includes a card body 1 and an IC module 2 which is embedded in and flush-mounted on a front surface 1A of the card body 1. The IC module 2 includes a module substrate 5 having a plurality of terminal contacts 3 formed on a front surface thereof and having an IC chip (not shown) mounted and encapsulated with resin on a rear surface of the module substrate 5. The IC chip (not shown) is electrically connected to the terminal contacts 3 formed on the front surface of the module substrate 5 through not-shown connection means.

According to the present invention, the card body 1 includes a plurality of elongated through-holes, namely, slits 4 (4A, 4B, 4C, 4D) formed to penetrate through the card body from the front surface 1A to a rear surface 1B of the card body 1. In the shown embodiment, the IC module 2 is square in a plan view, and the plurality of slits 4 consists of four slits located to substantially surround a periphery of the IC module 2. More specifically, each of the slits 4 extends in parallel to a corresponding side of four sides of the square IC module, separately from the corresponding side, and each of the four slits 4 has a length substantially equal to that of a corresponding side of the square IC module. Opposite ends of each slit (for example, 4D) terminate in the proximity of opposite corners (2B and 2C) of the corresponding side (2A) of the square IC module 2, respectively, separately from an adjacent end of an adjacent elongated slit (4A and 4B). Furthermore, each of the slits completely penetrates through the card body so that a mouth 41 formed in the front surface 1A of the card body 1 by the slit 4 is substantially the same in shape and in size as a mouth 42 formed in the rear surface 1B of the card body 1 by the same slit 4.

Thus, the card body 1 is substantially divided, by the slits 4, into an inside portion of the slits including the IC module 2 and an outside portion of the slits.

The shown embodiment of the IC card can be formed as follows. First, a recess 8 for receiving the IC module, is formed on the front surface 1A of the card body 1, which is formed of for example a vinyl chloride resin. At this time, the slits 4 are formed to penetrate through the card body 1, at four positions separated from the recess 8 to substantially surround the recess 8. Then, the IC module 2 is fitted into the recess 2 and bonded to the card body 1 by adhesive, so that the IC module 2 is embedded in and flush-mounted on the front surface 1A of the card body 1.

In the shown embodiment of the IC card, a major portion of a stress such as a bending or a twisting, applied to the card body 1 from an external and to propagate toward the IC module 2 from various directions, is cut off at the slits 4. The remaining stress (which has not been cut off at the slits 4) is concentrated to a portion other than the slits 4, namely, four joint portions 9 joining between the inside portion of the slit and the output side portion of the slit for supporting the inside portion of the slit including the IC module 2. However, since these joint portions 9 are formed of a flexible material such as a vinyl chloride resin as mentioned above and are remarkably small in a sectional size substantially orthogonal to the stress propagating direction, the remaining stress is greatly attenuated by flexibility of the narrow joint portions 9, so that most of the stress is not transferred to a mounting portion of the IC module 2. As a result, an external stress causing a trouble of the IC module and the IC chip included in the IC module, is not transferred to the IC module, and therefore, a highly reliable operation of the IC card can be ensured.

In addition, since neither an expensive material such as a polyimide film nor a special delicate working is required, the cost of the IC card can be lowered.

Referring to Fig. 3, there is shown a diagrammatic partial sectional view illustrating a second embodiment of the IC card in accordance with the present invention. In Figs 3, elements corresponding to those shown in Figs. 2A and 2B are given the same Reference Numerals.

As seen from comparison between Fig. 2B and Fig. 3, the second embodiment is different from the first embodiment only in that the slits 4 are filled with a flexible filler 7, which is formed of for example a rubber.

The second embodiment can exert the same advantage as that obtained in the first embodiment, and also has an additional advantage in which since the slits 4 are filled with the flexible filler 7, it is possible to avoid a mechanical interference such as a situation that contacts of an IC card reader/writer to be contacted to the contacts 3 of the IC card are caught by the slits 3 when the IC card is inserted into or exhausted from the IC card reader/writer.

The invention has thus been shown and described with reference to the specific embodiments. However, it should be noted that the present invention is in no way limited to the details of the illustrated structures but changes and modifications may be made within the scope of the appended claims.

## Claims

1. An IC card including a card body and an IC module embedded in the card body, the card body including a plurality of slits formed to penetrate through the card body and located to surround a periphery of the IC module.

2. An IC card claimed in Claim 1 wherein the IC module is rectangular in a plan view, and the plurality of slits consists of four slits, each of which extends in parallel to a corresponding side of four sides of the rectangular IC module, separately from the corresponding side, wherein each of the four slits has a length substantially equal to that of a corresponding side of the rectangular IC module, and wherein opposite ends of each slit terminate in the proximity of opposite corners of the corresponding side of the rectangular IC module, respectively, separately from an adjacent end of an adjacent elongated slit.

3. An IC card claimed in Claim 2 wherein each of the slits completely penetrates through the card body so that a mouth formed in one surface of the card body by the penetrating slit is substantially the same in shape and in size as a mouth formed in the other surface of the card body by the same penetrating slit.

4. An IC card claimed in Claim 3 wherein each of said slits is filled with a flexible filler.

5. An IC card claimed in Claim 4 wherein said flexible filler is formed of a rubber.

6. An IC card claimed in Claim 1 wherein each of said slits is filled with a flexible filler.

7. An IC card claimed in Claim 6 wherein said flexible filler is formed of a rubber.
